(19)

Europäisches
Patentamt
European
Patent Office
Office européen
des brevets

(11) **EP 4 765 187 A1**

(12) **EUROPEAN PATENT APPLICATION**

(43) Date of publication:
**24.06.2026  Bulletin 2026/26**

(21) Application number: **24222641.3**

(22) Date of filing: **20.12.2024**

(51) International Patent Classification (IPC):
*H01J 37/32* (2006.01)

(52) Cooperative Patent Classification (CPC):
**H01J 37/32568; H01J 37/32174; H01J 37/32577; H01J 37/32605**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Ruhr-Universität Bochum, Körperschaft des öffentlichen Rechts 44801 Bochum (DE)**

(72) Inventors:
• **LI, Wang**
  **44799 Bochum (DE)**
• **Julian, Schulze**
  **45529 Hattingen (DE)**
• **Peter, Hartmann**
  **1025 Budapest (HU)**
• **Zoltán, Donko**
  **2040 Budaörs (HU)**

(74) Representative: **Michalski Hüttermann & Partner mbB**
**Kaistraße 16A**
**40221 Düsseldorf (DE)**

(54) **DEVICES AND METHODS FOR PLASMA PROCESSING AND SURFACE PROCESSING**

(57)      According to the invention, a plasma processing device (1), a plasma generating method and a wafer surface processing method are provided. The plasma processing device comprises: a reacting chamber (11), and a powered sidewall electrode (14) which is driven by a radio frequency, RF voltage or DC voltage and is movably fixed to the sidewall (111) of the reacting chamber. By providing an individually RF driven electrode to the sidewall of the reacting chamber, energetic electrons are generated and driven to move radially towards the center of the reacting chamber, possibly interacting with the sheath at the wafer electrode to improve the plasma properties, e.g. the uniformity of plasma across the wafer surface, thereby improving the wafer surface processing quality.

Fig. 1

**Description**

The invention relates to the technical field of plasma and semiconductor processing. In particular, the invention relates to devices and methods for plasma processing and wafer/substrate surface processing.

Plasma processing devices are critical tools in industries such as semiconductor manufacturing, where precise control of surface modifications is essential. These devices utilize plasma - a partially ionized gas containing free electrons, ions, and neutral particles - to facilitate processes such as etching, deposition, modification and cleaning. Commonly used plasma generating techniques include radio frequency (RF) plasma, such as, capacitively coupled plasma (CCP), inductively coupled plasma (ICP), and so on.

Conventional plasma processing devices typically feature a reactor equipped with a grounded electrode and a powered electrode. Additionally, the reactor sidewall is usually grounded. Applying a voltage to a given configuration of the electrodes creates the electric fields necessary for plasma generation. In many designs, the powered electrode is fixed at the bottom of the reactor, while the upper electrode is positioned at the top. This arrangement generates a vertical electric field that supports the plasma formation and stability.

Alternatively other reactor designs can be used, e.g., the plasma can be generated by applying an RF voltage waveform to a planar or solenoidal antenna/coil. This can be realized in reactors of different geometries, where the walls are all grounded or an additional bias electrode is used to accelerate ions towards a wafer.

However, existing devices face challenges in achieving uniform plasma density across the wafer/substrate processing area. Multiple factors have been identified to cause radial plasma nonuniformities. For example, edge effects induced by structured boundaries inside the reactor, different materials of the wafer, electrodes and sidewalls, as well as electromagnetic effects including the propagation and interference of electromagnetic waves inside the sheaths and the skin effect.

Uneven plasma distribution can result in inconsistent material processing, particularly in advanced applications requiring high precision for larger wafer/substrate size, such as microfabrication for integrated circuits. Fixed electrode configurations also limit the ability to customize plasma characteristics for specific processes.

To address these challenges, some devices incorporate passive sidewall electrodes to supplement the fluxes and energy distribution within the components. Despite this improvement, conventional sidewall electrodes are often immobile and cannot be adjusted in height, tilt, or other configurations. This lack of adaptability reduces the effectiveness of sidewall electrodes in controlling plasma density and electric field distribution.

Moreover, current devices often fail to provide sufficient flexibility in voltage parameters, such as frequency, amplitude, and phase, which are critical for optimizing plasma behavior. The inability to independently tune these parameters for different electrodes further limits process efficiency and uniformity.

There is a growing demand for plasma processing devices that offer enhanced control over electrode configurations and RF voltage parameters. Such advancements would enable more precise tailoring of plasma properties, improving uniformity and efficiency in surface processing. Additionally, methods that leverage these enhanced devices to refine plasma generation and wafer/substrate surface processing are increasingly desirable to meet the stringent demands of modern manufacturing.

It is therefore the object of the present invention to provide a plasma processing device and corresponding processing methods which enhance plasma generation and improve the processing uniformity.

According to the invention, this object is addressed by the subject matter of the independent claims. Embodiments of the invention are described in the dependent claims.

Therefore, according to an aspect of the invention, a plasma processing device is provided. The plasma processing device comprises a reacting chamber, and a powered sidewall electrode driven by a RF voltage or a DC voltage. The powered sidewall electrode is movably fixed to the sidewall of the reacting chamber.

Here, the reacting chamber may be an enclosed space where plasma is generated, and the wafer/substrate surface is processed. The reacting chamber may be controlled under specific conditions of temperature and pressure. The reacting chamber may contain different gas mixtures for generating plasma.

Optionally, the plasma processing device may employ different plasma generation techniques, such as CCP, multi frequency RF Plasma, ICP, Helicon, magnetized plasmas and so on. When combining with different plasma generation techniques, the plasma processing device may comprise other corresponding components.

According to an embodiment of the present invention, the plasma processing device may further comprise an upper electrode fixed to the top of the reacting chamber and a bottom electrode fixed to the bottom of the reacting chamber. The upper electrode or the bottom electrode may be driven by another RF or DC voltage.

Specifically, the plasma processing device may comprise a powered upper electrode driven by RF or DC voltages and a bottom electrode or the plasma processing device may comprise a powered bottom electrode driven by RF or DC voltages and a upper electrode. Alternatively, the powered electrode to excite plasma may be arranged at different locations of the reacting chamber.

According to an alternative embodiment of the present invention, the plasma processing device may further comprise a wafer electrode fixed to the reacting chamber and an antenna or a coil to generate the plasma. The antenna or the coil may be placed above or surrounding the reacting chamber. The antenna or the coil may be driven by an external applied voltage to generate magnetic fields for producing plasma. Optionally, the wafer electrode may be powered, grounded or biased. The wafer electrode can be fixed to the top or the bottom of the reacting chamber. The wafer electrode may serve as a wafer holder.

Optionally, the upper electrode or the bottom electrode may function as the gas inlet, distributing reactive gases uniformly into the chamber to ensure consistent plasma generation. This electrode may either be grounded, electrically isolated or driven by a voltage with lower RF frequency or any other type of voltage waveform.

The upper electrode or the bottom electrode may also serve as a wafer holder, where the wafer/substrate is placed during plasma surface processing. All electrodes can be planar electrodes, graded conductivity electrodes, electrodes with trenches and so on.

In one specific example, the upper grounded electrode may serve as the gas inlet and the powered bottom electrode may serve as the wafer holder. In another example, the powered upper electrode may serve as the gas inlet and the bottom electrode may serve as the wafer holder and is grounded.

The powered sidewall electrode may be insulated from the sidewall of the reacting chamber and the sidewall of the reacting chamber may be grounded.

Optionally, all electrodes may be detachably fixed to the reacting chamber, and it is possible to replace any of the electrodes according to practical needs.

The range of RF used in the plasma processing device may fall between 1kHz and 300GHz, as defined by the general RF spectrum. Specifically, the RF frequency used may be 13.56 MHz, 400 kHz to 2 MHz or 27.12 MHz. Different RF frequencies may be chosen based on process requirements, such as temperature, plasma density, ion energy, and uniformity.

By providing a powered sidewall electrode, which is driven by an individual RF voltage waveform, energetic electron beams are generated at the sidewall and propagate radially inwards towards the chamber center to interact with the modulated RF sheath at the electrode holding the wafer. This interaction leads to significant or customized local ionization peaks at the electrode edge, thereby improving the radial plasma uniformity at low pressures and the surface processing precision. In addition, this configuration allows independent control of the upper electrode, bottom electrodes and sidewall electrodes for enhanced plasma characteristics and improved surface processing quality of the wafer/substrate.

According to an embodiment of the present invention, the RF or DC voltage driving the powered electrode and the RF or DC voltage driving the powered sidewall electrode may have the same or different frequency, amplitude, and/or phase. Optionally, the RF or DC voltages can be continuous wave or pulsed waveforms.

According to an embodiment of the present invention, both voltage waveforms applied to the powered electrode and the powered sidewall electrodes may also contain multiple frequency components with individually adjustable phases and amplitudes. The sidewall electrode may also be driven by a pulsed voltage waveform to generate energetic electrons that propagate towards the wafer electrode. The powered electrode can be the powered upper electrode or the powered bottom electrode.

A synchronization between the voltage waveforms applied to the powered electrode and the sidewall electrode ensures uniform plasma distribution. Specifically, these two RF voltage waveforms may be identical. In other words, RF voltages with identical frequency, amplitude and phase are applied respectively to the powered electrode and the powered sidewall electrode. This specific example facilitates improving the uniformity across the processing area drastically. In another example, these two RF voltages may have a phase difference of 180°, which may enhance the plasma density at a different radial position, for example the reactor center, of the reacting chamber while improving uniformity. Different combinations of the RF voltages can be chosen based on the processing requirements.

According to an embodiment of the invention, the plasma processing device may include an RF power supply unit connected to the powered electrode through a blocking capacitor and another RF power supply unit connected to the powered sidewall electrode through a blocking capacitor. Alternatively, the RF power supplies are connected to the electrodes via impedance matching networks. Optionally, the RF power supplies are connected to the electrodes via impedance matching networks comprising blocking capacitors. The powered electrode can be the powered upper electrode or the powered bottom electrode.

Alternatively, one RF power supply may be connected to all powered electrodes simultaneously. For example, to the powered bottom electrode and the powered sidewall electrodes. The upper electrode may be grounded.

These components ensure efficient delivery of RF power to the electrodes while blocking the direct current (DC) components, thus facilitating the formation of a stable plasma while enabling the development of DC self-biases on the powered electrodes.

According to an embodiment of the invention, the reacting chamber may have a cylindrical shape, and the powered sidewall electrode may comprise an annular electrode or multiple electrodes distributed along its circumference and insulated from each other.

Different geometries of the reacting chamber can be employed to facilitate the creation of a uniform plasma and enhanced particle distribution functions at the wafer to achieve consistent processing outcomes.

Optionally, the sidewall electrodes may be movably fixed to the inner surface of the sidewall. The annular-shaped sidewall electrodes may be sleeved to the inner circumference of the sidewall. The sidewall electrodes may also be movably fixed to the outer surface of the sidewall. For instance, the annular-shaped electrodes may also be sleeved to the outer circumference of the reacting chamber if the sidewall is made of dielectric material. In another example, the sidewall electrodes may be movably fixed to the reacting chamber via a fixing mechanism, like screws or bolts. Vertical tracks or rails may be provided in the sidewall to enable the vertical positioning of the sidewall electrode.

According to an embodiment of the invention, the powered sidewall electrode may be surrounded by grounded guard rings positioned around its upper and lower edges. The width of these guard rings may equal the width of the electrode edges, with a specified distance between the guard rings and the electrode edges. This configuration minimizes edge effects induced by the geometry of the sidewall electrodes. The specified distance can be 5 mm. Alternatively, the specified distance can be any value ranging from 1 mm to 2 cm, for example, 8 mm, 1 cm or 1.5 cm and so on.

Optionally, each of the grounded guard rings has a thickness that ranges from 1 mm to 2 cm in the vertical direction. For example, the grounded guard rings can have a thickness of 8 mm, 1 cm, 1.5 cm and so on.

Optionally, corresponding grounded guard rings can also be positioned around the outer circumference of the powered electrode other than the powered sidewall electrode. In this case, this grounded guard ring may have a height equal to the height of powered electrode. Optionally, the distance between this grounded guard ring and the outer circumference of the powered bottom electrode may also be 5 mm. This grounded guard ring may also have a radial width of 5 mm. As discussed above, the powered electrode may be the powered upper electrode or the powered bottom electrode.

According to an embodiment of the invention, the powered sidewall electrode may have a height of 3 cm and a width of 2 cm.

The size of the powered sidewall electrode may be chosen based on the dimension of the reacting chamber and/or the powered electrode so as to improve the uniformity of plasma generation. The powered sidewall electrode may have an outer diameter equal to or smaller than the diameter of the reacting chamber, when fixed to the inner surface of the sidewall. Alternatively, the powered sidewall electrode may have an inner diameter equal to or slightly larger than the diameter of the reacting chamber, when being fixed to the outer surface of the sidewall. The powered electrode can be the powered upper electrode or the powered bottom electrode.

In some embodiments, the cylindrical reacting chamber may have a radius of 50 cm, while the powered bottom electrode may be a planar electrode with a thickness of 3 cm and a radius of 30 cm. The distance between the upper electrode and the top surface of the powered bottom electrode may be 4 cm. These dimensions improve plasma confinement, enhance processing capabilities and can be applied to wafer with larger size.

Alternatively, different dimensions can be used for the reacting chamber and the electrode. For example, the reacting chamber may have a diameter from 10 to 120 cm and a height from 15 to 200 cm.

Optionally, when the plasma processing device comprises a powered electrode and a grounded arranged in opposite directions. the grounded electrode may be larger than the powered electrodes to enhance the development of a DC self-bias voltage. Alternatively, the grounded electrode may also have the same size as the powered electrode. Different dimensions of the reacting chamber and the electrodes may be employed according to processing requirements.

In one specific example, the grounded upper electrode is larger than or equal to the powered bottom electrode. In another specific example, the grounded bottom electrode is larger than or equal to the powered upper electrode.

According to an embodiment of the invention, the powered sidewall electrode may be movably fixed to the sidewall of the reacting chamber and can move up and down. Additionally, the tilt angle of the powered sidewall electrode relative to the sidewall of the reacting chamber may be adjustable.

These features enable dynamic customization of plasma properties. Corresponding vertical tracks and rails can be provided in the sidewall electrode and the reacting chamber to enable a precise vertical movement. An adjusting screw can be integrated into the sidewall electrode or the sidewall to change a distance between part of the sidewall electrodes and the sidewall, allowing precise tilt-angle adjustment by varying the screw depth.

According to an embodiment of the invention, the powered sidewall electrode may be driven by multiple frequency RF voltages. Alternatively, when the powered sidewall electrode comprises multiple electrodes that are distributed along its circumference, each electrode may be individually driven by separate RF voltages. These separate RF voltages may have the same frequency, amplitudes and/or phase. Each electrode may also be driven by separate multi-frequency RF voltage with individually adjustable phases and voltage amplitudes.

Optionally, multiple RF power supply units or RF power supply unit with multiple frequency channels may be provided to realize the multiple RF frequency control. Each channel may be connected to the electrodes through corresponding blocking capacitors or impedance matching networks. Alternatively, all frequency channels may be connected via a single multi-frequency impedance matching network. Optionally, the multiple electrodes may be evenly distributed along the circumference of the powered sidewall electrodes.

This arrangement enables complex plasma electric field configurations for diverse applications and further improves the flexibility of the device.

According to an embodiment of the invention, the powered sidewall electrode may be made of one of the following materials: metal, graphite, or metal with a ceramic coating. The material selection improves durability and compatibility with various plasma environments, contributing to increased longevity and process versatility. Other material choices are also possible.

According to another aspect of the invention, a method for generating plasma using the plasma processing device discussed above is provided. The method proposes to provide gas in the reacting chamber and apply individual RF voltages or DC voltages to both the powered electrode and the powered sidewall electrode. Or the method may apply individual voltages to the antenna or coil and the powered sidewall electrode.

When RF voltages are applied, the RF voltages may have matching frequency, amplitude, and/or phase like discussed above. Optionally, the RF voltages may also comprise multi-frequency RF waveforms with individually adjustable phases and amplitudes.

Here, the gas refers to reacting gas from which the plasma is generated for surface processing of wafer/substrate. The gas may be uniformly injected into the reacting chamber via the upper electrode or the bottom electrode which serves as a gas inlet. The gas may be uniformly distributed in the reacting chamber with a fixed gas temperature at a gas pressure. For instance, the gas temperature can be 400 K and the gas pressure can be 1 Pa. The configuration of the plasma processing device allows for plasma processing at low pressure. The temperature and the pressure may vary depending on the processing requirements.

According to an embodiment of the invention, the method further includes adjusting the vertical position of the powered sidewall electrode and/or the tilt angle between the powered sidewall electrode and the sidewall of the reacting chamber. These adjustments enable dynamic control over plasma characteristics.

The vertical position and/or the tilt angle of the powered sidewall electrode may be adjusted before or during the plasma and surface processing. In a specific example, the method may adjust the vertical position and/or tilt angle of the sidewall electrode before providing the gas. Optionally, the tilt angle may be adjusted by tightening or loosening the adjusting screw or other adjustment mechanism.

By adjusting the position and the tilt angle of the sidewall electrode, it is possible to adjust the plasma characteristics according to the need of surface processing, thus enhancing adaptability of the plasma generation process to suit different operational requirements.

As discussed above, the sidewall electrode may be detachably fixed to the sidewall. Thus, the method may further comprise the step of installing and/or changing the powered sidewall electrode before the adjustment and the gas injection.

According to an embodiment of the invention, the RF voltage applied to the powered bottom electrode and the powered sidewall electrode may have a frequency of 13.56 MHz and an amplitude of 500 V. Optionally, the voltages may have the same phase.

Different RF frequencies and amplitudes can be applied. The frequency may vary from 1 kHz and 300 GHz. The amplitude may vary from 5 V to 20000 V. Multiple simultaneously applied continuous wave or pulsed RF voltage waveforms may also have different phases. For instance, the phase difference is between 0° to 360°, such as 90°, 180° and 270°.

According to an embodiment of the invention, the gas used in the plasma generation method may include at least one of the following: etching gases, deposition gases, inert gases, or cleaning gases. This versatility enables the device to support a wide range of plasma-based processes. Gases for different processing purposes may be chosen according to practical needs.

The etching gases which remove wafer/substrate material during microfabrication may comprise one of sulfur hexafluoride ($SF_6$), chlorine ($Cl_2$), hydrogen bromide (HBr), HF, $CF_4$, $C_4F_8$, $CHF_3$, $BCL_3$ and so on. The deposition gases which add layers to surfaces may comprise one of silane ($SiH_4$), ammonia ($NH_3$), or dichlorosilane ($SiCl_2H_2$). The inert gases may include argon (Ar), helium (He), nitrogen ($N_2$) and so on. The cleaning gases may include fluorine ($F_2$), oxygen ($O_2$), carbon tetrafluoride ($CF_4$) and so on.

According to another aspect of the invention, a method for surface processing of a wafer/substrate is provided. The method involves placing the wafer/substrate within the reacting chamber and generating plasma using the described method. The plasmas are then used to process the wafer's surface.

Optionally, the wafer/substrate may be placed above the powered bottom electrode or the grounded bottom electrode, or the wafer electrode when the plasma processing device uses antenna or coil. Due to the improved uniformity of the plasma, the surface processing quality of the wafer/substrate is also improved.

**Brief description of the drawings**

In the following, the invention is described in further detail with reference to the drawing by means of an embodiment of the invention. These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:

Fig. 1   schematically depicts a side cross-sectional view of a block diagram illustrating a plasma processing device according to an embodiment of the present invention,

Fig. 2   schematically depicts a side cross-sectional view of a block diagram illustrating a plasma processing device according to another embodiment of the present invention,

Fig. 3   schematically depicts a side cross-sectional view of a block diagram illustrating a plasma processing device according to another embodiment of the present invention,

Fig. 4   exemplarily and schematically depicts a simulation result illustrating the plasma generation for different RF voltages applied.

Fig. 5   schematically depicts a flow chart of a plasma generating method according to an embodiment of the present invention, and

Fig. 6   schematically depicts a flow chart of a surface processing method according to an embodiment of the present invention.

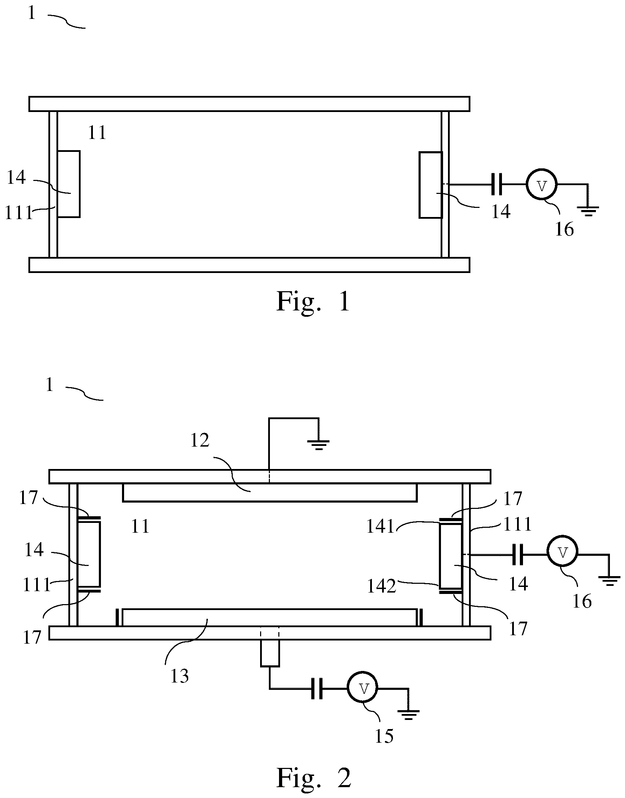

Fig. 1 schematically depicts the side cross-sectional view of the block diagram illustrating the plasma processing device 1 according to an embodiment of the present invention.

As shown in Fig. 1, the plasma processing device 1 comprises a reacting chamber 1 1and a powered sidewall electrode 14 movably fixed to the sidewall 111 of the reacting chamber. The powered sidewall electrode 14 is driven by a radio frequency, RF voltage or a DC voltage.

As discussed above, the powered sidewall electrode can be used together with CCP or ICP. When using with ICP, the plasma processing device 1 may further include a wafer electrode fixed to the reacting chamber and an antenna or a coil to generate the plasma. In some specific examples, the wafer electrode can be fixed to the bottom of the reacting chamber, and the antenna and/or coil may be placed above or surrounding the reacting chamber. Other arrangements of the wafer electrode and the antenna and/or coil can also be employed.

Alternatively, the plasma processing device 1 may further include an upper electrode 12 and a bottom electrode 13 fixed to the reacting chamber. One of the upper electrodes or the bottom electrode is driven by another RF or DC voltage individual to the sidewall driving voltage. The other electrode may be grounded, electrically isolated, or controlled by a low frequency RF waveform or any other waveforms.

Fig. 2 schematically depicts the side cross-sectional view of the block diagram illustrating the plasma processing device 1 according to an embodiment of the present invention as an example for a CCP plasma source.

As shown in Fig. 2, the plasma processing device 1 comprises a reacting chamber 11, an upper electrode 12 fixed to the top of the reacting chamber, a powered bottom electrode 13 which is driven by a RF or DC voltage and fixed to the bottom of the reacting chamber, and a powered sidewall electrode 14 which is driven by another RF or DC voltage and is movably fixed to the sidewall 111 of the reacting chamber.

Specifically, a first RF voltage $V_{RF1}$ can be applied to drive the bottom electrode and a second RF voltage $V_{RF2}$, which is independent from $V_{RF1}$, can be applied to the sidewall electrode. As discussed above, the addition of the second RF voltage $V_{RF2}$ enables sheath heating at the sidewall of the reacting chamber and thus makes it possible to improve the plasma uniformity or adjust the plasma characteristics.

The waveform of the two voltages may be expressed by the following equation (1) and equation (2):

$$V_{RF1}(t) = V_1 cos(2\pi f_1 t) \qquad\qquad (1)$$

and

$$V_{RF2}(t) = V_2 cos(2\pi f_2 t + \phi) \qquad\qquad (2)$$

According to the equations, $V_1$ refers to the amplitude of the first RF voltage $V_{RF1}$ applied to the bottom electrode. $f_1$ refers to the frequency of $V_{RF1}$. Similarly, $V_2$ refers to the amplitude of the second RF voltage $V_{RF1}$ applied to the sidewall

electrode and $f_2$ refers to the frequency of $V_{RF2}$. In addition, the second voltage $V_{RF2}$ may have a phase shift $\phi$ comparing to the first voltage $V_{RF1}$. $\phi$ refers to the phase different between the $V_{RF1}$ and $V_{RF2}$.

Optionally, the waveform of the two voltages could be composed of N frequencies with individually adjustable amplitudes and phases as expressed by equation (3) and (4):

$$V_{RF1}(t) = \sum_1^N V_{1,n} cos\left(2\pi f_{1,n} t + \phi_{1,n}\right) \qquad (3)$$

and

$$V_{RF2}(t) = \sum_1^N V_{2,n} cos\left(2\pi f_{2,n} t + \phi_{2,n}\right) \qquad (4)$$

Optionally, the RF voltage $V_{RF1}$ driving the powered bottom electrode 13 and the other RF voltage $V_{RF2}$ driving the powered sidewall electrode 14 may have the same frequency, amplitude and/or phase. In some embodiments, $V_{RF2}$ may be identical to $V_{RF1}$. Different combinations may be configured based on the processing needs. Optionally, one of/both of the two applied voltages can be DC voltages and one of/both of the two voltages can be continuous/pulsed wave.

As depicted in Fig. 2, the plasma processing device 1 may further comprise a RF power supply unit 15 connected to the powered bottom electrode through a blocking capacitor, and another RF power supply unit 16 connected to the powered sidewall electrode through blocking capacitor. Of course, although not shown in Fig. 2, the power supply may be connected to the corresponding electrodes via impedance matching networks comprising blocking capacitors.

By using an independent RF power supply unit, it is possible to avoid signal interference and ensure the robustness of the processing device 1. Blocking capacitors and impedance matchings may be applied to block external DC components while allowing the development of a DC self-bias during plasma processing. In some embodiments, the capacitances of the blocking capacitors and other electrical circuit elements of the impedance matchings, e.g., inductances, may be adjustable. Alternatively, the same RF power supply may be used to drive the powered bottom and sidewall electrodes.

The reacting chamber 11 shown in Fig. 2 has a symmetric shape as an example. According to one embodiment of the present invention, the plasma processing device may have a reaction chamber 11 with a cylindrical shape, and the powered sidewall electrode 14 may comprise an annular electrode. Alternatively, the powered sidewall electrode 14 may have an annular shape and include multiple electrodes distributed along its circumference and insulated from each other. Another alternative is that the powered sidewall electrode 14 may be a graded conductivity electrode, realized by covering the annular electrode with a dielectric ring composed of several segments made of dielectrics or metal with different conductivities. Additionally, trenches may be inserted into the annular electrodes to adjust their characteristics. In some embodiments, the sidewall electrode 14 may comprise multiple independent electrodes fixed along the circumference of the sidewall 111.

Fig. 2 also schematically depicts grounded guard rings surrounding the edges of the powered electrodes 13, 14 to reduce edge effects.

Specifically, the plasma processing device 1 may comprise grounded guard rings 17 surrounding an upper edge 141 and a lower edge 142 of the powered sidewall electrode 14. The width of the grounded guard rings 17 may be equal to the width of the upper and lower edges and the distance between the grounded guard rings 17 and the edges 141, 142 can be specified, for example 5 mm, or 1 cm. The guard rings shown in Fig. 2 may also have a thickness of 5 mm or any value between 1 mm to 2 cm.

As shown in Fig. 2, corresponding grounded guard rings can also be positioned around the outer circumference of the powered bottom electrode. The grounded guard ring may have a radial width of 5 mm and a height equal to the height of bottom electrode. The distance between this grounded guard ring and the outer circumference of the powered bottom electrode may also be specified, for example, 1 mm, 5 mm or any value between 1 mm to 2 cm.

In one specific embodiment of the invention, the annular powered sidewall electrode 14 has a vertical height of 3 cm and a ring width of the 2 cm. Additionally, the reacting chamber 11 may have a radius of 14 cm with a planar bottom electrode 13 which has a thickness of 3cm and a radius of 8cm. The distance between the upper electrode 12 and the top surface of the powered bottom electrode 13 may be 4cm.

Alternatively, the reacting chamber may have a radius of 50cm with a planar powered electrode 13 which has a radius of 30 cm. Different dimensions may be chosen based on practical needs.

In this embodiment, the height ratio between the sidewall electrode and the gap is 3:4. The sheath heating expansion at the sidewall electrode can be distributed evenly in the vertical direction. Different dimensions may be chosen based on practical needs.

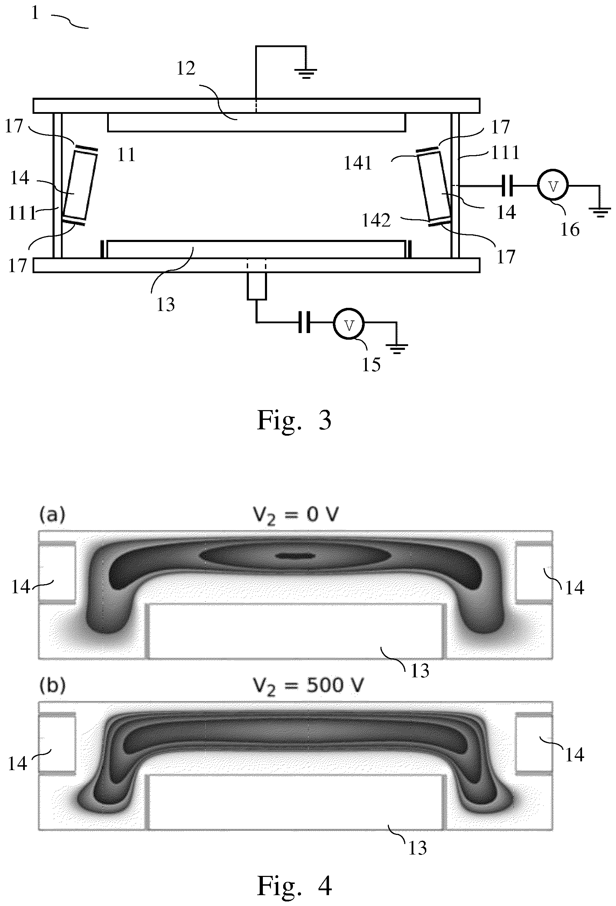

Although not shown in Fig. 2, the powered sidewall electrode 14 may be vertically movable, fixed to the sidewall of the reaction chamber, and/or have an adjustable tilt angle between the powered sidewall electrode 14 and the sidewall 111 of the reaction chamber. Fig. 3 shows an example of the present invention wherein the sidewall electrode is tilted against the normal direction of the sidewall 111.

As discussed above, conventional fixing mechanisms, such as sleeve fittings, screwing, and so on, may be applied. Guiding tracks and rails may be provided on the sidewall 111 and the sidewall electrode 14, respectively, to allow precise positioning. Optionally, an adjusting screw through the sidewall 111 may be provided to adjust the distance between the sidewall and the sidewall electrode for tilt-angle adjustment. Multiple adjusting screws can also be provided for symmetrical adjustment.

According to some embodiments of the invention, the powered sidewall electrode may be driven by a multiple frequency RF voltage. Alternatively, when the powered side wall electrode comprises multiple electrodes that distributed along its circumference and insulated from each other, the multiple electrodes may be driven by individual RF voltages or a single RF voltage waveform.

Additionally, the powered sidewall electrode may be made of different materials which may comprise metal, graphite, and metal with ceramic coating and so on. Commonly used materials may include aluminum, graphite, molybdenum, stainless steel, silicon carbide, tungsten and so on.

Simulation results prove that the application of a second RF voltage to the sidewall electrodes improves the uniformity of the plasma. Fig. 4 depicts the simulated electron density distribution with the voltage amplitude $V_2$ applied to the sidewall electrode being set to (a) 0V and (b) 500V. The first voltage amplitude $V_1$ is set to be 500V. $f_1 = f_2$ = 13.56 MHz, Phase difference $\phi$ is 0, and pressure of the argon gas is 1 Pa.

It can be seen from Fig. 4(a) that a strong non-uniform center-high plasma density profile is formed in the absence of any voltage applied to the sidewall. Applying an RF voltage to the sidewall electrode results in a drastic improvement of the radial plasma uniformity. Results also show different level of uniformity improvement when $V_{RF2}$ is not identical to $V_{RF1}$. For example, when a phase different of 180° is set, the plasma density at the center of the reacting chamber is enhanced while the uniformity is improved slightly. Thus, different combinations of the RF voltages can be chosen based on the processing requirements.

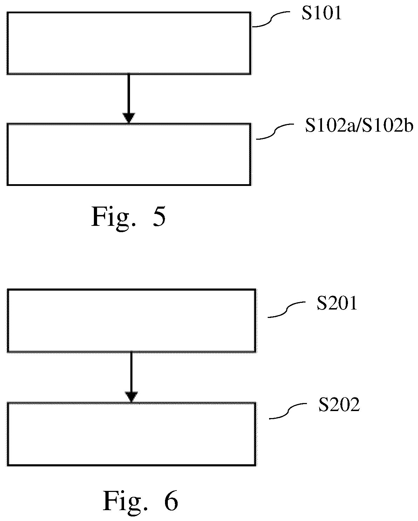

Fig. 5 depicts a method for generating plasma using the plasma processing device with an individually RF driven sidewall electrode as discussed before. The method comprises the following steps:

S101: providing gas in the reacting chamber, and
S102a: applying individual voltages to the powered upper electrode or the powered bottom electrode and the powered sidewall electrode, or
S102b: applying individual voltages to the antenna or coil and the powered sidewall electrode.

The individual voltages may be RF voltages or DC voltages. The individual RF voltages may have the same or different frequencies, amplitudes and/or phases. In one specific embodiment, the RF voltages $V_{RF1}$ and $V_{RF1}$ may be identical. In a specific example, the RF voltage applied to the powered electrode and the RF voltage applied to the powered sidewall electrode may have a frequency of 13.56 MHz and an amplitude of 500V. Different combinations of continuous/-pulsed RF/DC voltages can be chosen based on practical needs.

Alternatively, multiple-frequency RF voltages may be applied to the powered electrode and/or sidewall electrode. This may enhance the uniformity of the plasma. Specifically, multiple-frequency RF voltages may be applied to the powered bottom electrode and/or the powered sidewall electrode. Or multiple-frequency RF voltages may be applied to the powered upper electrode and/or the powered sidewall electrode

According to another embodiment of the invention, the method may further comprise the following steps:

S103: adjusting a vertical position of the powered sidewall electrode, and/or
S104: adjusting a tilt angle between the powered sidewall electrode and the sidewall of the reacting chamber.

As discussed above, the vertical position and/or the tilt angle of the powered sidewall electrode may be adjusted before or during the plasma and surface processing. In a specific example, the method may adjust the vertical position and/or tilt angle of the sidewall electrode before providing the gas. The position and tilt angle of the powered sidewall electrode may be adjusted as detailed above.

Additionally, the method may further comprise the step of installing and/or changing the powered sidewall electrode before the adjustment S103, S104 and the gas injection S101.

Further, the gas used in the plasma generation method may include at least one of the following: etching gases, deposition gases, inert gases, or cleaning gases for different processing purposes.

Fig. 6 depicts a method for surface processing of a wafer/substrate according to an embodiment of the present invention. The method uses the plasma processing device and applies the plasma generating method as discussed above.

Specifically, the method comprises the step of:

S201: providing a wafer or a substrate inside the reacting chamber, and

S202: generating plasma using the plasma processing method as detailed above to process a surface of the wafer.

The wafer/substrate can be placed above the electrode serving as the wafer holder.

For the purpose of completion, assuming that the powered bottom electrode serves as the wafer holder, the process of surface processing is described as follows. First, a wafer or substrate to be processed may be placed on the powered bottom electrode. If the powered bottom electrode is integrated with a wafer holder, the wafer or substrate can be placed on the wafer holder. Then, the corresponding reactive gas may be uniformly distributed into the chamber at a certain temperature and pressure. If the surface processing involves etching, etching gases are injected. Similarly, if the process involves cleaning or deposition, cleaning gases or depositioning gases are injected. After the reactive gas is injected, individual RF voltages may be applied to the bottom electrode and the sidewall electrode, respectively. Optionally, the position and tilt angle of the sidewall electrode may be adjusted before the placement of the wafer or the injection of gas.

Of course, if the grounded bottom electrode serves as the wafer holder, the wafer will be placed above the grounded bottom electrode and individual voltages will be applied to the powered upper electrode and the powered sidewall electrode.

Alternatively, if the plasma processing device uses antenna or coils, the wafer will be placed above the wafer electrode and individual voltages will be applied to the antenna or coils and the powered sidewall electrode.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to our advantage. Any reference signs in the claims should not be construed as limiting the scope. Further, for the sake of clearness, not all elements in the drawings may have been supplied with reference signs.

Reference symbol list

| | |
|---|---|
| 1 | plasma processing device |
| 11 | reacting chamber |
| 12 | upper electrode |
| 13 | powered bottom electrode |
| 14 | powered sidewall electrode |
| 15 | RF power supply unit for powered electrode |
| 16 | RF power supply unit for powered sidewall electrode |
| 17 | grounded guard rings |
| 111 | sidewall of reacting chamber |
| 141 | upper edge of powered sidewall electrode |
| 142 | lower edge of powered sidewall electrode |

**Claims**

1. A plasma processing device (1) comprising:

   a reacting chamber (11), and
   a powered sidewall electrode (14) movably fixed to the sidewall (111) of the reacting chamber,
   wherein the powered sidewall electrode (14) is driven by a radio frequency, RF voltage or a direct current, DC voltage.

2. Plasma processing device according to claim 1, comprising:

   an upper electrode (12) fixed to the top of the reacting chamber, and
   a bottom electrode (13) fixed to the bottom of the reacting chamber,
   wherein the upper electrode or the bottom electrode (13) is driven by another RF voltage or another DC voltage.

3. Plasma processing device according to claim 1, comprising:

   a wafer electrode fixed to the reacting chamber, and
   an antenna or a coil driven by an externally applied voltage, which is configured to generate plasma via magnetic fields.

4. Plasma processing device according to claim 1, wherein

   the RF voltage driving the powered sidewall electrode (14) and the other RF voltage driving the powered upper or bottom electrode (12, 13) have the same frequency, amplitude and/or phase, and/or
   the RF voltages driving the electrodes (12, 13, 14) comprises multi-frequency voltage waveforms with individually adjustable phases and amplitudes of all frequency components.

5. Plasma processing device according to claim 2, comprising:

   a RF power supply unit (15) connected to the powered upper electrode (12) or the powered bottom electrode (13) through a blocking capacitor or an impedance matching network, and
   another RF power supply unit (16) connected to the powered sidewall electrode (14) through another blocking capacitor or another impedance matching network.

6. Plasma processing device according to any of claims 1 to 5, wherein:

   the reacting chamber (11) has a cylindrical shape, and
   the powered sidewall electrode (14) comprises an annular electrode, or
   the powered sidewall electrode (14) has an annular shape and comprises multiple electrodes which are distributed along its circumference and insulated from each other.

7. Plasma processing device according to any of claims 1 to 6, comprising:
   grounded guard rings (17) surrounding an upper edge (141) and a lower edge (142) of the powered sidewall electrode (14).

8. Plasma processing device according to any of claims 1 to 7, wherein

   the powered sidewall electrode (14) is vertically movable fixed to the sidewall of the reacting chamber, and/or
   a tilt angle between the powered sidewall electrode and the sidewall of the reacting chamber is adjustable.

9. Plasma processing device according to any of claims 1 to 8, wherein

   the powered sidewall electrode comprises multiple electrodes that are distributed along its circumference and insulated from each other, and
   the multiple electrodes are driven by individual RF voltages.

10. Plasma processing device according to any of claims 1 to 10, wherein
    the powered sidewall electrode is made of one of the materials comprising: metal, graphite, and metal with ceramic coating.

11. Method for generating plasma using the plasma processing device according to any of claims 2 to 10, comprising the following steps:

    providing (S101) gas in the reacting chamber, and
    applying (S102a) individual voltages to the powered upper electrode (12) or the powered bottom electrode (13) and the powered sidewall electrode (14), or
    applying (S102b) individual voltages to the antenna or the coil and the powered sidewall electrode,
    wherein the individual voltages comprise continuous/pulsed RF voltages and/or DC voltages.

12. Method for generating plasma according to claim 11, further comprising the following steps:

    adjusting (S103) a vertical position of the powered sidewall electrode, and/or

adjusting (S104) a tilt angle between the powered sidewall electrode and the sidewall of the reacting chamber.

13. Method for generating plasma according to claim 12, wherein the RF voltage applied to the powered upper electrode or the powered bottom electrode, and the RF voltage applied to the powered sidewall electrode have the same frequency, amplitude and/or phase, and/or
the individual RF voltages comprising multi-frequency voltage waveforms with individually adjustable phases and amplitudes of all frequency components.

14. Method for generating plasma according to any of claims 11 to 13, wherein
the gas comprises at least one of the following: etching gases, deposition gases, inert gases, and cleaning gases.

15. Method for surface processing using the plasma processing device according to any of claims 2 to 10, comprising:

providing (S201) a wafer or a substrate inside the reacting chamber, and
generating (S202) plasma using the method according to any of claims 11 to 14 to process a surface of the wafer or the substrate.

1

11

14

111

16

Fig. 1

1

12

17    17

11    141    111

14    14

111    142

17    17

13

15

Fig. 2

Fig. 3

Fig. 4

S101

S102a/S102b

Fig. 5

S201

S202

Fig. 6

**EUROPEAN SEARCH REPORT**

Application Number

EP 24 22 2641

## DOCUMENTS CONSIDERED TO BE RELEVANT

| Category | Citation of document with indication, where appropriate, of relevant passages | Relevant to claim | |
|---|---|---|---|
| X | US 2008/135518 A1 (CHEN LEE [US] ET AL) 12 June 2008 (2008-06-12) | 1-5,7,8, 10-15 | **CLASSIFICATION OF THE APPLICATION (IPC)** |
| Y | * abstract; figures 1-3,6,8 * * paragraphs [0001], [0027] - [0046], [0049], [0054] - [0057] * | 6,9 | INV. H01J37/32 |
| | ----- | | |
| Y | US 2024/331988 A1 (LIAO JING-CHENG [TW] ET AL) 3 October 2024 (2024-10-03) | 6,9 | |
| A | * abstract; claims 1-6; figures 1,2,4 * * paragraphs [0002], [0015] - [0027], [0044], [0045], [0046] * | 1-5,7,8, 10-15 | |
| | ----- | | |
| A | US 2009/236214 A1 (JANAKIRAMAN KARTHIK [US] ET AL) 24 September 2009 (2009-09-24) * abstract; figures 2A,2B,4 * * paragraphs [0002], [0026] - [0041], [0043] - [0046] * | 1-15 | |
| | ----- | | **TECHNICAL FIELDS SEARCHED (IPC)** |
| | | | H01J |

The present search report has been drawn up for all claims

| Place of search | Date of completion of the search | Examiner |
|---|---|---|
| The Hague | 3 June 2025 | Remy, Jérôme |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

....................................................................................

& : member of the same patent family, corresponding
    document

EPO FORM 1503 03.82 (P4C01)

## ANNEX TO THE EUROPEAN SEARCH REPORT
## ON EUROPEAN PATENT APPLICATION NO.

EP 24 22 2641

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2025

| Patent document cited in search report | | | Publication date | Patent family member(s) | | Publication date |
|---|---|---|---|---|---|---|
| US 2008135518 | A1 | | 12-06-2008 | JP | 5219479 B2 | 26-06-2013 |
| | | | | JP | 2008147659 A | 26-06-2008 |
| | | | | US | 2008135518 A1 | 12-06-2008 |
| US 2024331988 | A1 | | 03-10-2024 | CN | 109585247 A | 05-04-2019 |
| | | | | TW | 201916163 A | 16-04-2019 |
| | | | | US | 2019103256 A1 | 04-04-2019 |
| | | | | US | 2020395200 A1 | 17-12-2020 |
| | | | | US | 2020402779 A1 | 24-12-2020 |
| | | | | US | 2024331988 A1 | 03-10-2024 |
| US 2009236214 | A1 | | 24-09-2009 | CN | 101978474 A | 16-02-2011 |
| | | | | CN | 103594340 A | 19-02-2014 |
| | | | | JP | 2011519117 A | 30-06-2011 |
| | | | | JP | 2014053309 A | 20-03-2014 |
| | | | | KR | 20100126510 A | 01-12-2010 |
| | | | | SG | 189685 A1 | 31-05-2013 |
| | | | | TW | 200952565 A | 16-12-2009 |
| | | | | US | 2009236214 A1 | 24-09-2009 |
| | | | | US | 2012205046 A1 | 16-08-2012 |
| | | | | US | 2016145742 A1 | 26-05-2016 |
| | | | | WO | 2009117173 A1 | 24-09-2009 |

EPO FORM P0459

For more details about this annex : see Official Journal of the European Patent Office, No. 12/82